# EUROPÄISCHE PATENTANMELDUNG

(11) **EP 4 685 847 A1**
(43) Veröffentlichungstag der Anmeldung: **28.01.2026**
(21) Anmeldenummer: 25182720.0
(22) Anmeldetag: 13.06.2025
(51) Int. Cl.: H01L 23/14, H01L 23/373

(54) **LEISTUNGSMODUL UND VERFAHREN ZUR HERSTELLUNG EINES LEISTUNGSMODULS**

(30) Priorität: 25.07.2024 DE 102024207008
(71) Anmelder: VOLKSWAGEN AG, 38440 Wolfsburg (DE)
(72) Erfinder: Bayer, Christoph Friedrich, 97776 Eußenheim (DE); Müller, Jens Uwe, 34246 Vellmar (DE); Wilke, Robert, 20457 Hamburg (DE); Kraft, Silke, 91126 Schwabach (DE); Yuan, Jing, 34134 Kassel (DE); Otto, Alexander, 34311 Naumburg (DE); Pihale, Sven, 91792 Stopfenheim (DE); Hiller, Sebastian, 92318 Neumarkt (DE)

(57) **Zusammenfassung**

Die Erfindung betrifft ein Leistungsmodul (1) umfassend einen thermisch leitfähigen und elektrisch isolierenden Träger (2), auf dem mindestens eine strukturierte Metalllage (4) aufgebracht ist, auf der mindestens ein Leistungshalbleiter (5) angeordnet ist, wobei das Leistungsmodul (1) mindestens eine Isolationsschicht (6) aufweist, auf der mindestens eine Metallschicht (7) angeordnet, wobei die Isolationsschicht (6) derart auf dem Träger (2) angeordnet ist, dass der mindestens eine Leistungshalbleiter (5) nicht durch die Isolationsschicht (6) bedeckt wird, wobei auf der mindestens einen Metallschicht (7) mindestens eine Signalleitung und/oder Steuerleitung angeordnet ist, die über eine elektrische Verbindung mit der Metalllage (4) verbunden sein kann sowie ein Verfahren zur Herstellung eines solchen Leistungsmoduls (1)

## Beschreibung

Die Erfindung betrifft ein Leistungsmodul und ein Verfahren zur Herstellung eines Leistungsmoduls.

Derartige Leistungsmodule weisen typischerweise einen thermisch leitfähigen und elektrisch isolierenden Träger auf, auf dem mindestens eine strukturierte Metalllage aufgebracht ist. Der Träger ist beispielsweise eine Al2O3-, Si3N4- oder AIN-Keramik, wobei der Träger als DCB, AMB, DBA ausgebildet sein kann. Die strukturierte Metalllage ist beispielsweise aus Kupfer oder Aluminium und weist typischerweise Schichtdicken von 10 µm - 1 mm auf. Auf die Metalllage werden dann die Leistungshalbleiter montiert, deren erzeugte Verlustwärme über den Träger abgeführt werden kann. Dabei sind die Strukturen der Metalllage relativ groß im Vergleich zu Strukturen, die in Leiterplattentechnik oder IMS-Technik realisierbar sind. Ein weiterer Nachteil ist, dass diese Träger relativ teuer sind im Vergleich zu Leiterplatten.

Aus der EP0221399B1 ist ein gattungsgemäßes Leistungsmodul bekannt, das als Package bezeichnet wird. Das Package weist einen Träger und ein Laminat auf, wobei das Laminat eine Mehrzahl von verbundenen Laminatschichten aufweist. Der typische Aufbau eines Leistungsmoduls ist dabei von unten nach oben: Wärmesenke (z.B. Kühlkörper), keramischer Schaltungsträger (Metall, Keramik, Metall), Leistungshalbleiter + Verbindungsmaterialien, Isolationsmaterial, Gehäuse, Anschlüsse.

Ein Aspekt dieses Standardaufbaus ist, dass Signalleitung sowie auch Hochstromleitung mittels der keramischen Schaltungsträgertechnologie stattfindet, welche im Bezug auf die Strukturierung der Signalleitung und deren Platzbedarf durch den verwendeten keramischen Hochstromschaltungsträger stark überdimensioniert ist. Dies führt zu preistechnischen sowie auch elektrischen Nachteilen.

Der Erfindung liegt das technische Problem zugrunde, ein Leistungsmodul zu schaffen, das kompakt, elektrisch performanter und preisgünstig ist, wobei die Probleme aufgrund des hohen Platzbedarfs von Leiterbahnen auf keramischen Schaltungsträgern reduziert sind. Ein weiteres technisches Problem ist, ein geeignetes Herstellungsverfahren bereitzustellen.

Die Lösung des technischen Problems ergibt sich durch ein Leistungsmodul mit den Merkmalen des Anspruchs 1 sowie ein Herstellungsverfahren mit den Merkmalen des Anspruchs 8. Weitere vorteilhafte Ausgestaltungen der Erfindung ergeben sich aus den Unteransprüchen.

Das Leistungsmodul umfasst einen thermisch leitfähigen und elektrisch isolierenden Träger, auf dem mindestens eine strukturierte Metalllage aufgebracht ist, auf der mindestens ein Leistungshalbleiter angeordnet ist. Weiter weist das Leistungsmodul mindestens eine Isolationsschicht auf, auf der mindestens eine Metallschicht angeordnet ist. Dabei ist die Isolationsschicht derart auf dem Träger angeordnet, dass der mindestens eine Leistungshalbleiter nicht bedeckt wird, wobei auf der mindestens einen Metallschicht mindestens eine Signalleitung und/oder Steuerleitung angeordnet ist, die über eine elektrische Verbindung mit der Metalllage verbunden ist. Anschaulich werden die Signal- und/oder Steuerleitungen auf die Metalllage verlagert, wo diese erheblich kleiner strukturiert ausgebildet werden können, sodass der Träger insgesamt etwas kleiner ausgebildet sein kann, was Kosten spart. Da die Isolations- und Metallschicht nicht auf dem Leistungshalbleiter aufliegen, ist die thermische Belastung erheblich geringer als wenn diese auch über den Leistungshalbleiter liegen würden. Die Isolations- und Metallschicht können dabei sehr unterschiedlich hergestellt werden, beispielsweise als PCB-, IMS- oder Flex-Leiterebenen oder auch aufgedruckt werden. Vorzugsweise weist der Träger auf der Unterseite ebenfalls eine Metalllage auf, mittels derer der Träger mit einer Kühlplatte oder ähnlichem verbunden werden kann.

In einer Ausführungsform ist auf der Metallschicht mindestens eine weitere Isolationsschicht aufgebracht, wobei auf der weiteren Isolationsschicht mindestens eine weitere Metallschicht mindestens teilweise aufgebracht ist. Beispielsweise ist auf der weiteren Metallschicht ein Bauelement angeordnet, z. B. ein Temperatursensor.

In einer weiteren Ausführungsform sind die Metalllage und die erste Metallschicht abschnittsweise direkt verbunden, sodass darüber die elektrische Verbindung hergestellt werden kann.

In einer weiteren Ausführungsform ist die Metalllage abschnittsweise unterhalb der ersten Isolationsschicht teilweise entfernt. Hierdurch können speziell isolierende Bereiche geschaffen werden.

Dabei kann der abschnittsweise entfernte Teil der Metalllage mit der ersten Isolationsschicht aufgefüllt werden.

In einer weiteren Ausführungsform ist durch die Strukturierung der Isolations- und Metallschichten ein Bauelement (z. B. ein Kondensator oder eine Induktivität) oder eine Schirmung ausgebildet.

Dabei sei angemerkt, dass die Isolationsschichten und Metallschichten aus verschiedenen Materialien ausgebildet sein können und so an ihre jeweilige Funktion optimal angepasst werden.

Das Verfahren zur Herstellung eines Leistungsmodules weist den Schritt auf, dass eine Metalllage eines thermisch leitfähigen und elektrisch isolierenden Trägers strukturiert wird, wobei auf die strukturierte Metalllage mindestens ein Leistungshalbleiter aufgebracht wird. Weiter werden eine Isolationsschicht und eine auf der Isolationsschicht aufgebrachte Metallschicht derart auf die strukturierte Metalllage aufgebracht, dass der oder die Leistungshalbleiter nicht bedeckt werden, wobei mindestens eine elektrische Verbindung zwischen der Metalllage und der mindestens einen Metallschicht hergestellt wird.

Die Isolationsschicht kann zeitgleich im selben Prozessschritt wie der mindestens eine Leistungshalbleiter auf die Metalllage aufgebracht werden. Die Isolationsschicht kann aber auch zeitlich davor oder danach aufgebracht werden.

In einer weiteren Ausführungsform werden mindestens eine Isolationsschicht und mindestens eine Metallschicht als vorgefertigte Einheit auf die Metalllage oder eine Metall- oder Isolationsschicht aufgebracht, was Vorteile bei der Fertigungsgeschwindigkeit hat.

Die Erfindung wird nachfolgend anhand bevorzugter Ausführungsbeispiele näher erläutert. Die Figuren zeigen:
- Fig. 1: eine schematische Darstellung eines Teils eines Leistungsmoduls in einer ersten Ausführungsform,
- Fig. 2: eine schematische Darstellung eines Teils eines Leistungsmoduls in einer zweiten Ausführungsform,
- Fig. 3: eine schematische Darstellung eines Teils eines Leistungsmoduls in einer dritten Ausführungsform,
- Fig. 4: eine schematische Darstellung eines Teils eines Leistungsmoduls in einer vierten Ausführungsform und
- Fig. 5: eine schematische Darstellung eines Teils eines Leistungsmoduls in einer fünften Ausführungsform.

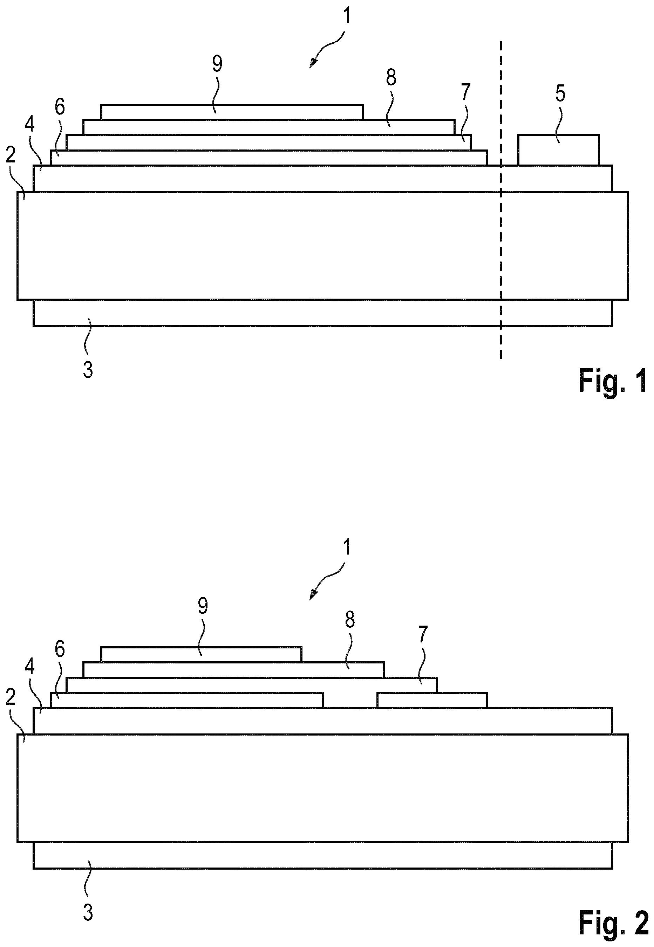

In der Fig. 1 ist stark vereinfacht ein Teil eines Leistungsmodules 1 dargestellt. Das Leistungsmodul 1 weist einen Träger 2 aus einer Keramik auf, der auf der Unterseite eine Metalllage 3 und auf der Oberseite eine strukturierte Metalllage 4 aufweist, auf der mindestens ein Leistungshalbleiter 5 angeordnet ist. Des Weiteren ist auf der Metalllage 4 eine Isolationsschicht 6 angeordnet, die derart auf der Metalllage 4 aufgebracht ist, dass der Leistungshalbleiter 5 nicht bedeckt wird. Auf der Isolationsschicht 6 ist eine Metallschicht 7 aufgebracht, auf der wieder eine zweite Isolationsschicht 8 aufgebracht ist. Auf der zweiten Isolationsschicht 8 ist abschließend eine weitere Metallschicht 9 aufgebracht. Die gestrichelte Linie deutet dabei an, dass es Bereiche gibt, wo der oder die Leistungshalbleiter 5 angeordnet sind, und es Bereiche gibt, wo die Schichten 6 - 9 angeordnet sind. In den nachfolgenden Darstellungen wird nur der Bereich dargestellt, wo die Schichten 6 - 9 angeordnet sind.

In der Fig. 2 ist eine Ausführungsform dargestellt, wo ein Teil der Isolationsschicht 6 entfernt wurde, sodass die erste Metallschicht 7 die Metalllage 4 kontaktiert.

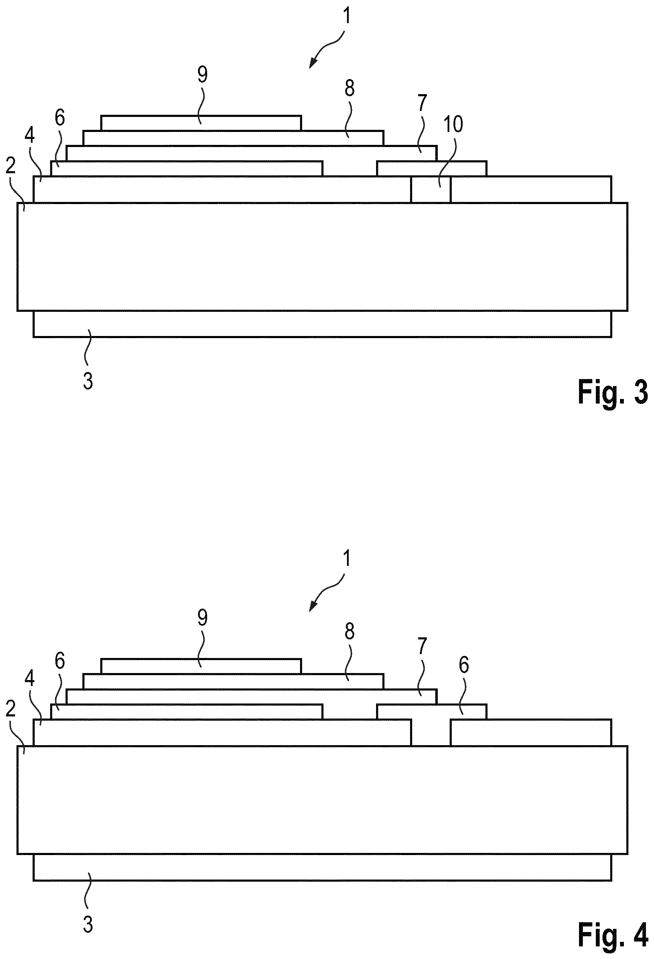

In der Fig. 3 ist zusätzlich ein Teil der Metalllage 4 entfernt, sodass eine Isolationskammer 10 sich ausbildet, um beispielsweise verschiedene Bereiche besser elektrisch voneinander zu isolieren, wobei die Isolationskammer 10 auch mit dem Material der Isolationsschicht 7 aufgefüllt werden kann, was in Fig. 4 dargestellt ist.

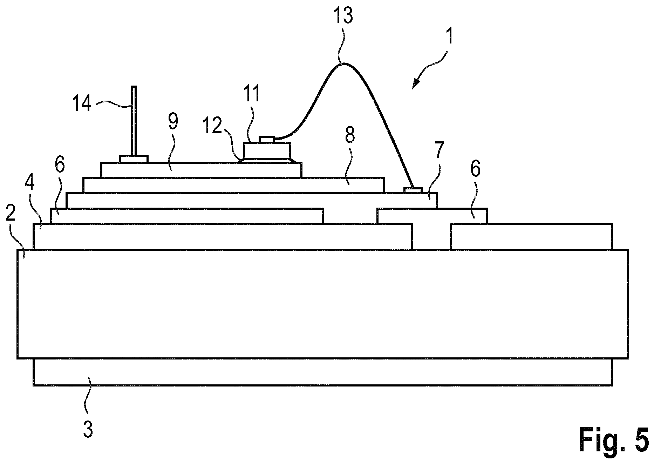

In der Fig. 5 ist schließlich dargestellt, dass auf der Metallschicht 9 ein Bauelement 11 angeordnet ist, das mittels einer Lotverbindung 12 auf der Metallschicht 9 elektrisch leitend verbunden ist, wobei das Bauelement 11 über einen Bonddraht 13 mit der Metallschicht 7 verbunden ist. Über die elektrische Verbindung zur Metalllage 4 kann so z. B. ein Kelvin-Source-Kontakt eines Leistungshalbleiters 5 herausgeführt werden. Das Bauelement 11 kann auch ein Gate-Vorwiderstand sein. Weiter ist ein Ball-Drahtbond 14 dargestellt.

Über die Metallschicht 7, 9 können so Signal- und Steuerleitungen der Leistungshalbleiter 5 herausgeführt werden, wobei die Standard-Verbindungstechniken flexibel zu Anwendung kommen.

Dabei sei angemerkt, dass vorzugsweise das Leistungsmodul 1 nach der Fertigstellung mit einer Moldmasse vergossen wird.

### Bezugszeichenliste

- 1): Leistungsmodul
- 2): Träger
- 3): Metalllage
- 4): strukturierte Metalllage
- 5): Leistungshalbleiter
- 6): Isolationsschicht
- 7): Metallschicht
- 8): Isolationsschicht
- 9): weitere Metallschicht
- 10): Isolationskammer
- 11): Bauelement
- 12): Lotverbindung
- 13): Bonddraht
- 14): Ball-Drahtbond

## Patentansprüche

1. Leistungsmodul (1), umfassend einen thermisch leitfähigen und elektrisch isolierenden Träger (2), auf dem mindestens eine strukturierte Metalllage (4) aufgebracht ist, auf der mindestens ein Leistungshalbleiter (5) angeordnet ist, wobei das Leistungsmodul (1) mindestens eine Isolationsschicht (6) aufweist, auf der mindestens eine Metallschicht (7) angeordnet, **dadurch gekennzeichnet, dass** die Isolationsschicht (6) derart auf dem Träger (2) angeordnet ist, dass der mindestens eine Leistungshalbleiter (5) nicht durch die Isolationsschicht (6) bedeckt wird, wobei auf der mindestens einen Metallschicht (7) mindestens eine Signalleitung und/oder Steuerleitung angeordnet ist, die über eine elektrische Verbindung mit der Metalllage (4) verbunden sein kann.

2. Leistungsmodul nach Anspruch 1, **dadurch gekennzeichnet, dass** auf der Metallschicht (7) mindestens eine weitere Isolationsschicht (8) mindestens teilweise aufgebracht ist, wobei auf die weitere Isolationsschicht (8) mindestens eine weitere Metallschicht (9) mindestens teilweise aufgebracht ist.

3. Leistungsmodul nach Anspruch 2, **dadurch gekennzeichnet, dass** auf der mindestens einen Metallschicht (7) und/oder der weiteren Metallschicht (9) ein Bauelement (11) angeordnet ist.

4. Leistungsmodul nach Anspruch 2 oder 3, **dadurch gekennzeichnet, dass** die Metalllage (4) und die erste Metallschicht (7) abschnittsweise direkt verbunden sind.

5. Leistungsmodul nach einem der vorangegangenen Ansprüche, **dadurch gekennzeichnet, dass** die Metalllage (4) abschnittsweise unterhalb der ersten Isolationsschicht (6) teilweise entfernt ist.

6. Leistungsmodul nach Anspruch 5, **dadurch gekennzeichnet, dass** der abschnittsweise entfernte Teil der Metalllage (4) mit der ersten Isolationsschicht (6) aufgefüllt ist.

7. Leistungsmodul nach einem der vorangegangenen Ansprüche, **dadurch gekennzeichnet, dass** durch die Strukturierung der Isolations- und Metallschichten (6 - 9) ein Bauelement oder eine Schirmung ausgebildet ist.

8. Verfahren zur Herstellung eines Leistungsmoduls (1), wobei eine Metalllage (4) eines thermisch leitfähigen und elektrisch isolierenden Trägers (6) strukturiert wird, wobei auf die strukturierte Metalllage (4) mindestens ein Leistungshalbleiter (5) aufgebracht wird, wobei auf die Metalllage des Trägers (2) mindestens eine Isolationsschicht (6) und auf die Isolationsschicht (6) mindestens eine Metallschicht (7) aufgebracht werden, **dadurch gekennzeichnet, dass** die Isolationsschicht (6) derart auf die Metalllage (4) aufgebracht wird, dass die Leistungshalbleiter (5) nicht bedeckt werden, wobei mindestens eine elektrische Verbindung zwischen der Metalllage (4) und der mindestens einen Metallschicht (7) hergestellt wird.

9. Verfahren nach Anspruch 8, **dadurch gekennzeichnet, dass** mindestens die Isolationsschicht (6) zeitgleich im selben Prozessschritt wie der mindestens eine Leistungshalbleiter (5) auf die Metalllage (4) aufgebracht wird.

10. Verfahren nach Anspruch 8 oder 9, **dadurch gekennzeichnet, dass** mindestens eine Isolationsschicht (6, 8) und mindestens eine Metallschicht (7, 9) als vorgefertigte Einheit auf die Metalllage (4) oder eine Metall- oder Isolationsschicht (7, 6) aufgebracht werden.
